# EUROPEAN PATENT SPECIFICATION

(11) **EP 1 133 405 B1**
(45) Date of publication and mention of the grant of the patent: **16.04.2003**
(21) Application number: 99973275.3
(22) Date of filing: 01.12.1999
(51) Int. Cl.: B60K 37/06, H03K 17/96

(54) **TOUCH SENSITIVE SWITCH**
BERÜHRUNGSEMPFINDLICHER SCHALTER
COMMUTATEUR TACTILE

(30) Priority: 04.12.1998 GB 9826704
(43) Date of publication of application: 19.09.2001
(73) Proprietor: Ford Motor Company Limited, Brentwood, Essex CM13 3BY (GB); FORD-WERKE AKTIENGESELLSCHAFT, 50735 Köln (DE); FORD FRANCE S.A., 92506 Rueil-Malmaison Cédex (FR); Ford Motor Company, Dearborn, MI 48126 (US)
(72) Inventor: BUTLER, Bryan, Frederick, Essex CM12 9UN (GB); NOLAN, Stephen, Anthony, Huntington Woods, MI 48070 (US)
(74) Representative: Simons, Alison Diane
(86) International application number: GB9904006
(87) International publication number: WO00034068

(56) References cited:
- DE-A- 2 200 918
- US-A- 4 497 982
- US-A- 5 808 374

## Description

The present invention relates to a touch sensitive switch for use on an automotive control panel.

Although many different types of touch sensitive switches have been developed, these have not been used to a great extent in automotive applications. One reason for this is that a driver has to concentrate on driving and wants switches which have a positive feel, where he knows that the correct position/switch/button has been properly engaged. Previously push buttons and rotating knobs have been popular.

Another automotive control panel according to the preamble of claim 1 is known from US-5,808,374.

According to the invention there is provided a touch sensitive switch for use on an automotive control panel to select the level of a parameter of operation of an automotive system comprising a hollowed out depression in an instrument panel defining a guide track extending between a first stop and a second stop, shaped and sized to receive the tip of a finger and allow it to be freely moved along the base of the track from one stop to the other, the base of the guide track including touch sensitive means such that the position along the track to which the finger is moved selects the level of the parameter.

The touch sensitive means may comprise a variable resistance rheostat or alternatively a series of separate microswitches. The choice of the type of touch sensitive means will be readily apparent to the skilled addressee of the specification.

The use of the invention allows the driver to get a positive feel that he has correctly engaged the switch by his finger moving into the track. His finger will engage against one stop of the track and then move along the track until the parameter has reached the required level. At the same time complexity on the instrument panel has been reduced since there are fewer moving parts to fail.

The guide track may be arcuate, annular or part annular or elongate and substantially linear. An elongate, linear guide track is a simple and convenient arrangement.

The stops are typically the end walls of the guide track - their presence is to define the start and finish of the guide track to aid the positive feel of the switch for the driver.

Typically the width of a guide track will be between 12 and 20mm and the depth will be between 2 and 4 mm. Preferably the width is substantially 16mm and the depth is substantially 3mm which is sized such that the tip of even the fattest finger will engage on the touch sensitive means.

Preferably the switch is multifunctional and is arranged as disclosed in our co-pending application filed at the same time as this application and entitled Automotive Control panel.

Thus the switch is for operating in at least two modes, a first mode in which the multifunctional switch controls a parameter of the audio system, and a second mode in which the multifunctional switch controls a parameter of the climate control system, the control panel also including a switch mode selector for selecting the mode of the multifunctional switch.

This allows the instrument panel to be simplified to provide more space and less clutter. The switch is one which selects a level for a particular parameter which is more complex than a selector switch switching between modes. Hitherto the controls of the different systems of the vehicle have been kept separate and therefore take up space.

Preferably the automotive control panel includes displays of the level of the parameters controlled. More preferably such displays are hidden until the switch is operating in the mode in which that parameter is controllable by the switch. In this way the driver only sees the information relevant to the audio system when changing the audio settings and the driver only sees the information relevant to the climate control system when changing the climate control settings.

Preferably such selective display is provided by using a 'secret - until -lit' material which carries a first printed layer on its obverse surface and a second printed layer on its reverse surface, the second printed layer being visible only when backlit.

Such a 'secret until lit' material is disclosed in International Patent application WO97/16812 and comprises a partially transparent tinted substrate layer carrying a first obverse layer and a second reverse layer, the second reverse layer carrying a first printed display, and the first obverse layer carrying a second printed display and being partially transparent coated with a transparent carrier supporting non opaque particulate light splitting or light frequency modulating materials such as mica coated with titanium dioxide. In ambient light the second printed display is visible and when a light of sufficient intensity is shone from a source located at the rear of the material the presence of the first printed display on the second reverse layer becomes visible and the second printed display becomes visible. A light emitting diode or sets of diodes can be used to provide the backlighting.

Thus in accordance with the present invention around the guide track are arranged a series of graduations which are printed on the reverse layer, one set of graduations corresponding to each parameter that the switch is arranged to control, each set of graduations having located behind it a set of LEDs which can be selectively illuminated dependant upon the mode in which the switch is operating.

Thus the driver only has to concentrate on one mode and one set of 'comfort information' at a time giving opportunity to concentrate on driving.

Moreover the combined display and switch unit for the climate control and audio unit saves space and money since fewer components are required.

A touch sensitive switch for an automotive control panel will now be described, by way of example, with reference to the attached drawings, in which:-
Figure 1 is a schematic view of an automotive control panel in one mode;
Figure 2 is a schematic view of the automotive control panel of figure 1, in a second mode; and
Figure 3 is an enlarged perspective view of the switch.

An automotive control panel 1 is provided with at least one multifunctional switch 3, for operating in at least two modes, a first mode in which the multifunctional switch 3 controls a parameter of the audio system, and a second mode in which the multifunctional switch controls a parameter of the climate control system, the control panel also including a switch mode selector 5, 7 for selecting the mode of the multifunctional switch.

The switch 3 is a touch sensitive switch for use to select the level of a parameter of operation of an automotive system dependant upon the mode of operation comprising a hollowed out depression 9 in the instrument panel 1 defining a guide track 11 extending between a first stop 13 and a second stop 15, said guide track shaped and sized to receive the tip of a finger and allow it to be freely moved along the base of the track 17 from one stop 13 to the other 15, the base of the guide track 17 including touch sensitive means 19 such that the position along the track to which the finger is moved selects the level of the parameter.

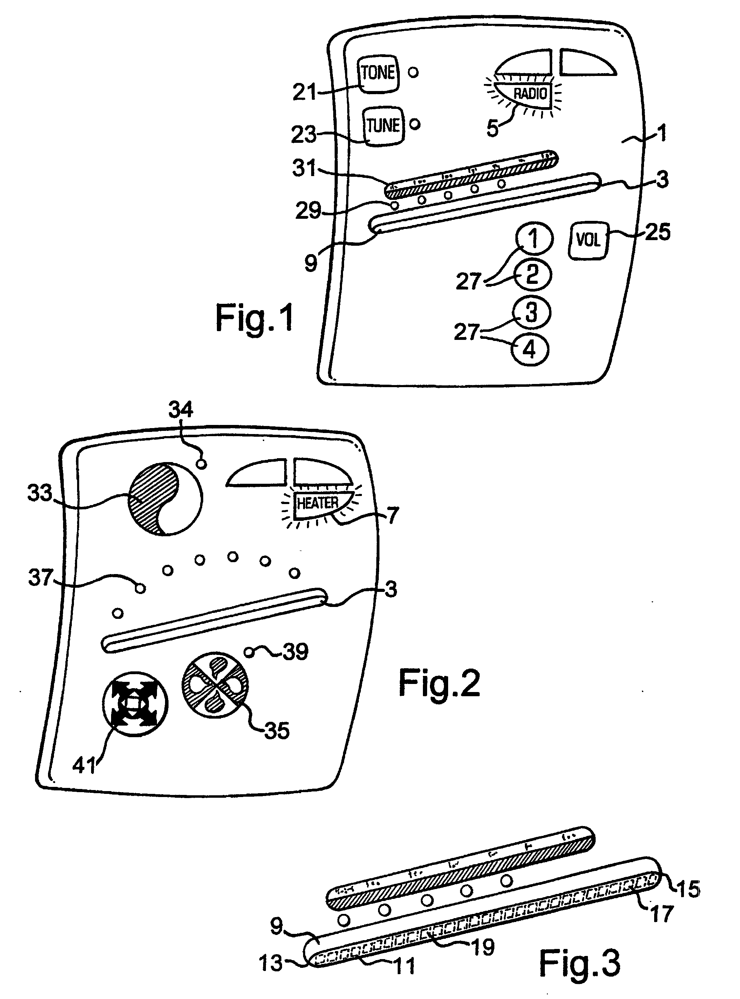

The automotive control panel 1 includes a plurality of switch mode selectors 5, 7, 21, 23, 25 which are depressed to select the mode of operation of the multifunctional switch 3. In this case the audio system is a radio, and in its first mode( illustrated in figure 1), the multifunctional switch 3 may control the Tone, the tuning and the Volume of the signal. In its second mode (illustrated in figure 2), the multifunctional switch 3 may control the temperature and the fan speed of the air conditioning unit.

The automotive control panel comprises a series of LED's mounted behind a secret until lit material such as that sold by John McGavigan Limited of Woodilee Road, Kirkintilloch, Glasgow G66 3UW and as described in their patent application WO 97/16812. Arranged behind the material are also a series of depressible switches for mode selection.

When the key is inserted in the ignition of the vehicle, the driver can see both switches 5 and 7, designated 'RADIO' and 'heater' respectively. When switch 5 is depressed, it becomes illuminated and the word RADIO shines in red. At the same time the switch 7 is not highlighted.

This switches the panel into radio control mode and a number of other switches and displays become visible as illustrated in figure 1. These include TONE button 21, TUNE button 23, VOLUME button 25, and preset radio station buttons 27 designated '1' '2' '3'and '4'.

If TONE button 21 is depressed, this selects a first mode of operation of the multifunctional switch. The output of the switch ( not illustrated) is thus connected to the tone variation of the radio.

Operation of the switch 3 has two results - the tone of the radio is changed and a display 29 is selectively illuminated The display comprises a series of markers, here spaced apart circles arranged along the edge of depression 9. As the finger of the driver moves to change the level of the tone more lights are illuminated.

If TUNE button 23 is depressed, this selects a third mode of operation of the multifunctional switch. The output of the switch ( not illustrated) is thus connected to the frequency selector of the radio.

Selection of TUNE button 23 also illuminates tuning display 31 which appears similar to a standard radio station display where the different frequencies are marked as graduations and a pointer moves up the graduations to illustrate the selected frequency.

Tuning display 31 is backlit only when TUNE button 23 has been operated so that once the correct tuning has taken place the driver need not be distracted further by the display.

An alternative method of selection of a predetermined station uses buttons 27 which can be used to select one of four preselected radio stations.

When VOLUME button 25 is depressed, this selects a fourth mode of operation of the switch 3 where the output of the switch is connected to the volume control of the radio. Operation of the switch again selectively illuminates the lights of display 29 - here the volume level is depicted by the number of markers illuminated along the length of the switch 3.

If HEATER button 7 is depressed, the LEDS positioned behind Buttons 21,23,25 and 27 and displays 29 and 31 are switched off and they become invisible. Heater button is illuminated by a red light and mode selector buttons 33 and 35 become illuminated as shown in figure 2.

In figure 2, the second mode of operation of the switch 3 is depicted. Here TEMPERATURE button 33 has been depressed and adjacent light 34 becomes illuminated. The output of switch 3 is then connected to the temperature control of the climate control system.

Operation of switch 3 causes the temperature to be selected and causes selective illumination of the markers here circles arranged in an arc running along the edge of switch 3) of display 37, again the number of circles illuminated depicting the temperature level selected.

A fifth mode of operation is selected by depressing button 35 which selects fan speed. Selection of this button illuminates adjacent light 39 and operation of switch 3 causes selective illumination of display 37, in this mode depicting the fan speed selected.

The direction is which the heat is directed is controlled by button 41 which illustrates four arrows which can be depressed to select desired heat source.

As can be seen from figures 1 and 2, none of the buttons or displays of the audio and climate control systems overlap ( apart from the multifunctional switch itself) so that it is possible to selectively backlight the respective displays so that only those relevant to the audio system are illuminated when parameters of the audio system are being changed, and only those displays relevant to the climate control system are illuminated when its parameters are being selected. At all other times those displays become invisible to the driver.

It will be apparent to the skilled addressee of the specification that many other functions of the audio and climate control system may be operated by the switch 3, and that its use is not limited to operation of those functions. For example the switch could be used for altering seat or mirror positions. Also many other forms of display can be used.

The structure of the switch itself is depicted in figure 3 where it can be seen that an elongate depression 9 in the instrument panel is in the form of a wide groove which is elongate and substantially linear. The groove is 16mm wide and 3mm deep - this is wide enough to allow the fattest finger to be slid along the groove and is deep enough to give the user a positive feel that his finger is correctly located without having to study the instrument panel carefully.

This is arranged on the instrument panel at a slight angle to the horizontal to form a guide track 11 which runs from left to right and upwards which gives the driver the impression of selecting a higher level of the parameter as his finger moves from left to right.

The end walls 13 and 15 of guide track 11 define stops which provide a definite feel for the driver as he operates the switch. Along the base 17 of the guide track are arranged a series of microswitches 19 ( shown in dotted line) - as a finger is run along the guide track, the microswitches are serially activated to select the level of the particular parameter being controlled at that time.

## Claims

1. A touch sensitive switch (3) for use on an automotive control panel (1) to select the level of a parameter of operation of an automotive system **characterized by** a hollowed out depression (9) in the automative control panel (1) defining a guide track (11) extending between a first stop (13) and a second stop (15), said guide track (11) being shaped and sized to receive the tip of a finger and allow it to be freely moved along the base (17) of the guide track (11) from one stop (13) to the other (15), the base (17) of the guide track (11) including touch sensitive means (19) such that the position along the track to which the finger is moved selects the level of the parameter.

2. A touch sensitive switch according to claim 1, in which the touch sensitive means (19) comprises a series of microswitches.

3. A touch sensitive switch according to claim 1 or 2, in which the guide track (11) is elongate and substantially linear.

4. A touch sensitive switch according to claim 3 in which the hollowed out depression (9) and guide track (11) are at an angle to the horizontal so that the guide track (11) runs from left to right and upwards.

5. A touch sensitive switch according to any one of the preceding claims, in which the depression (9) is substantially 16mm wide.

6. A touch sensitive switch according to any one of the preceding claims, in which the depression (9) is substantially 3mm deep.

## Patentansprüche

1. Berührungsempfindlicher Schalter (3) für den Einsatz in einem Kraftfahrzeug-Bedienpult (1) zur Wahl eines Pegels für einen Betriebsparameter in einem Kraftfahrzeugsystem, **gekennzeichnet durch**
eine ausgesparte Vertiefung (9) im Kraftfahrzeug-Bedienpult (1), welche eine Führungsbahn (11) bildet, die sich zwischen einem ersten Anschlag (13) und einem zweiten Anschlag (15) erstreckt, wobei besagte Führungsbahn (11) so gestaltet und bemessen ist, daß sie eine Fingerspitze aufnehmen kann und dieser erlaubt, frei entlang des Bodens oder der Bodenlinie (17) der Führungsbahn (11) von einem Anschlag (13) bis zum anderen (15) in der Führungsbahn (11) bewegt zu werden, wobei der Boden (17) berührungsempfindliche Mittel (19) beinhaltet, so daß die Position entlang der Führungsbahn, bis zu welcher der Finger bewegt worden ist, den Pegel für den jeweiligen Parameter anwählt.

2. Berührungsempfindlicher Schalter nach Anspruch 1, in welchem die berührungsempfindlichen Mittel (19) von einer Reihe von Mikroschaltern gebildet werden.

3. Berührungsempfindlicher Schalter nach Anspruch 1 oder 2, in welchem die Führungsbahn (11) länglich und im wesentlichen linear ist.

4. Berührungsempfindlicher Schalter nach Anspruch 3, in welchem die ausgesparte Vertiefung (9) und Führungsbahn (11) derart in einem Winkel zur Horizontalen verläuft, daß die Führungsbahn (11) von links nach rechts und aufwärts verläuft.

5. Berührungsempfindlicher Schalter nach einem beliebigen der vorangehenden Ansprüche, in welchem die Vertiefung (9) im wesentlichen 16 mm breit ist.

6. Berührungsempfindlicher Schalter nach einem beliebigen der vorangehenden Ansprüche, in welchem die Vertiefung (9) im wesentlichen 3 mm tief ist.

## Revendications

1. Commutateur tactile (3) destiné à une utilisation sur un tableau de bord d'automobile (1) pour sélectionner le niveau d'un paramètre de fonctionnement d'un système d'automobile, **caractérisé par** un retrait creusé (9) dans le tableau de bord d'automobile (1) définissant une piste de guidage (11) s'étendant entre une première butée (13) et une seconde butée (15), ladite piste de guidage (11) étant façonnée et dimensionnée pour recevoir l'extrémité d'un doigt et lui permettre d'être déplacé librement le long de la base (17) de la piste de guidage (11) d'une butée (13) à l'autre (15), la base (17) de la piste de guidage (11) incluant un moyen tactile (19) de sorte que la position le long de la piste à laquelle le doigt est déplacé sélectionne le niveau du paramètre.

2. Commutateur tactile selon la revendication 1, dans lequel le moyen tactile (19) comprend une série de microrupteurs.

3. Commutateur tactile selon la revendication 1 ou 2, dans lequel la piste de guidage (11) est allongée et sensiblement linéaire.

4. Commutateur tactile selon la revendication 3, dans lequel le retrait creusé (9) et la piste de guidage (11) font un angle par rapport à l'horizontal de sorte que la piste de guidage (11) va de gauche à droite et vers le haut.

5. Commutateur tactile selon l'une quelconque des revendications précédentes, dans lequel le retrait (9) est sensiblement d'une largeur de 16 mm.

6. Commutateur tactile selon l'une quelconque des revendications précédentes, dans lequel le retrait (9) est sensiblement d'une profondeur de 3 mm.
